# EUROPÄISCHE PATENTSCHRIFT

(11) **EP 1 997 135 B1**
(45) Veröffentlichungstag und Bekanntmachung des Hinweises auf die Patenterteilung: **21.03.2012**
(21) Anmeldenummer: 07723508.3
(22) Anmeldetag: 22.03.2007
(51) Int. Cl.: H01L 21/683, B23Q 3/15, H02N 13/00

(54) **VERFAHREN UND VORRICHTUNG ZUR ELEKTROSTATISCHEN FIXIERUNG VON SUBSTRATEN MIT EINER LEITFÄHIGEN SCHICHT**
METHOD AND DEVICE FOR ELECTROSTATICALLY FIXING SUBSTRATES HAVING A CONDUCTIVE LAYER
PROCÉDÉ ET DISPOSITIF DE FIXATION ÉLECTROSTATIQUE DE SUBSTRATS POURVUS D'UNE COUCHE CONDUCTRICE

(30) Priorität: 23.03.2006 DE 102006013516
(43) Veröffentlichungstag der Anmeldung: 03.12.2008
(73) Patentinhaber: Fraunhofer-Gesellschaft zur Förderung der angewandten Forschung e.V., 80686 München (DE)
(72) Erfinder: LANDESBERGER, Christof, 82166 Gräfelfing (DE); BOCK, Karlheinz, 82239 Alling (DE); KLINK, Gerhard, 82256 Fürstenfeldbruck (DE)
(74) Vertreter: Schenk, Markus
(86) Internationale Anmeldenummer: PCT/EP2007/002554
(87) Internationale Veröffentlichungsnummer: WO 2007/110191

(56) Entgegenhaltungen:
- EP-A- 1 662 559
- JP-A- 1 163 110
- US-A1- 2003 178 468

## Beschreibung

Die vorliegende Erfindung bezieht sich auf eine Fixierung von Substraten auf Trägersystemen durch elektrostatische Anziehung.

Die Herstellung von elektronischen Systemen auf flexiblen Substraten, wie beispielsweise Folien aus Kunststoff, Papier oder Metall, gewinnt zunehmend an Bedeutung. Als zukünftige Anwendungen seien hier genannt: flexible Displays, flexible Solarzellen, flexible Leuchtflächen und allgemein elektrische Schaltungen, die aufgrund der Flexibilität des Substrats sich leicht verformen lassen und somit vorgegebene Gehäusevolumen optimal platzsparend ausfüllen können.

Ein aktueller Entwicklungsschwerpunkt auf dem Gebiet der flexiblen Elektronik sind gedruckte Schaltungen auf der Basis von organischen Materialien, wie beispielsweise halbleitende Polymere, polymere Leiterbahnmaterialien, polymere Dielektrikas u.a.. Gerade die Drucktechnik bietet sich als eine sehr kostengünstige Verfahrenstechnik an. In Verbindung mit flexiblen Substraten können hierfür durchlaufende Rolle-zu-Rolle Produktionstechniken genutzt werden. Während der Entwicklungsphase von neuen Verfahren und Materialien für flexible Elektroniken sind durchlaufende Rolle-zu-Rolle-Prozesse allerdings zu aufwändig. Hier wäre es vorteilhaft, die flexiblen Substrate auch als Einzelblattbögen ("sheets") in Anlagen und Prozesssystemen bearbeiten zu können. Dies würde auch die Möglichkeit eröffnen, bereits vorhandene Produktionsanlagen auch für flexible Substrate nutzen zu können.

Die Handhabung einzelner, flexibler Substrate ist jedoch schwierig. Für Beschichtungsprozesse mit flüssigen Medien, Trocknungsvorgänge im Ofen oder bei lithografischer Strukturierung müssen die Folien flach auf einer Unterlage fixiert sein und sollen außerdem mit automatischen Handhabungssystemen verarbeitet werden können.

Einzelne flexible Folien können in Beschichtungsanlagen verarbeitet werden, wenn sie auf starre Substrate montiert werden. Eine einfache Variante hierfür ist das Ankleben der Ecken eines Folienbogens auf einer etwas größer dimensionierten, starren Trägerplatte mittels Klebeband. Dies ist aber mit erheblichem manuellen Aufwand verbunden. Auch ist das Abziehen der Klebebänder nach Temperaturschritten oft schwierig bzw. mit erheblichen Rückständen verbunden. Im Falle von Trocknungsprozessen auf Heizplatten ("hotplates") ist zudem kein gleichmäßiger, flächiger Wärmekontakt gegeben; Luftblasen und Aufwölbungen der Folien verhindern eine wirklich flache Auflage des Substratbogens. Ungleichmäßiger Wärmekontakt und gewellte Form des Substrats führen unweigerlich zu ungleichmäßigen Schichtdicken, was im Falle von leitenden oder halbleitenden Schichten zu stark variierenden und somit unbrauchbaren elektronischen Eigenschaften führt.

Eine vollflächige Verklebung von Folie mit Trägersubstrat ist grundsätzlich möglich; dann aber mit noch größerem Bearbeitungsaufwand verbunden. Wiederlösbare Klebetechniken stellen deshalb keine kostengünstige und praktikable Lösungen dar. Alternativ könnten die Folien auf perforierten Vakuumsaugplatten fixiert werden. Dann allerdings ist das automatische Beladen und Entladen der gewellten Folien weiterhin nicht sinnvoll gelöst.

Bekannt sind auch elektrostatische Haltetechniken für dünne Substrate, wobei man unipolare und bipolare Halterungen bzw. Träger unterscheidet. Im Fall des unipolaren Trägers weist die Trägerplatte nur eine Flächenelektrode auf und trägt dementsprechend nur Ladungen einer Polarität (unipolar). Bei einem bipolaren Träger wird eine Trägerplatte genutzt, die mindestens zwei elektrisch getrennte Flächenelektroden aufweist, die mit entgegengesetzter Polarität aufgeladen werden. Ein bipolarer Träger ist beispielsweise in JP11-163110 offenbart, der insbesondere für Glassubstrate geeignet ist, wobei der Glassubstrate eine leitfähige Schicht aufweisen. Eine Vorrichtung für einen unipolaren Träger ist in JP 59132139 beschrieben und ein entsprechendes Verfahren zur Halterung ist in der DE 10235814 B3 angegeben. Diese Halterung ist für elektrisch leitende Substrate geeignet, wobei zwischen dem Substrat und der Trägerplatte eine Schicht mit hoher Dielektrizitätskonstante gebracht wird, so dass die Fixierung des Substrats durch dielektrische Polarisation erfolgt. Außerdem ist ein mobiler Halter basierend auf einem bipolaren Träger in der WO 0211184 A1 beschrieben. Diese Halterung ist für Wafer vorgesehen.

Diese elektrostatischen Verfahren besitzen die Vorteile, eines guten flächigen Anpressdrucks, einer leichten Lösbarkeit des elektrostatischen Trägers und einer problemlosen Automatisierbarkeit. Es zeigt sich aber, dass Folien wie beispielsweise PET (PET = Poly-Ethylen-Terephtalat, Polyester) oder Polyimid zu geringe Haltekräfte gegenüber elektrostatischen Feldern aufweisen und diese Verfahren bzw. Vorrichtungen deswegen keine zuverlässige Halterung für diese Materialien liefern. Wegen der zunehmenden Bedeutung dieser Materialien ist die gegenwärtige Situation unbefriedigend.

Es ist die Aufgabe der vorliegenden Erfindung ein elektrostatisches Verfahren und eine Vorrichtung bereitzustellen, welche sich besonders für das reversible Fixieren von dünnen, flexiblen Substraten eignen und darüber hinaus eine hohe Haltekraft bei gutem flächigen Anpressdruck bieten.

Diese Aufgabe wird durch eine Vorrichtung gemäß Anspruch 1 und ein Verfahren gemäß Anspruch 9 gelöst.

Der vorliegenden Erfindung liegt die Erkenntnis zugrunde, dass Substrate, die an sich eine zu geringe Leitfähigkeit aufweisen, um mittels elektrostatischer Anziehung an einem Träger fixiert zu werden, dadurch auf einem Träger, der aus einer Trägerplatte und einer Flächenelektrode besteht, fixiert werden können, dass das Substrat mit einer leitfähigen Beschichtung versehen wird. Das Substrat kann dann derart auf dem Träger angeordnet werden, dass zwischen der leitfähigen Schicht und der Flächenelektrode sich eine Isolierschicht befindet, woraufhin eine elektrostatische Anziehung zwischen der leitfähigen Schicht und der Flächenelektrode bewirkt werden kann, um das Substrat an dem Träger zu befestigen. Die leitfähige Schicht kann eine Schicht darstellen, die mit Ausnahme der elektrostatischen Fixierung für keine weitere Funktionalität notwendig ist, so dass sie entfernt werden kann, wenn eine Fixierung nicht länger erforderlich ist. Statt einer leitfähigen Schicht kann auch eine Folie, die eine leitfähige Schicht aufweist, auf das Substrat aufgebracht werden und optional nach dem Durchführen des erfindungsgemäßen Handhabungsverfahrens wieder entfernt werden.

Dieses Verfahren eignet sich insbesondere für ein Fixieren von flexiblen Substraten, die keine oder für eine elektrostatische Anziehung zu geringe Leitfähigkeit aufweisen, wie beispielsweise Kunststofffolien oder dünne Halbleitersubstraten, die erfindungsgemäß mit einer leitfähigen Beschichtung versehen werden. Diese leitfähige Beschichtung kann beispielsweise eine Metallschicht sein. Eine vorteilhafte Ausführung ist darüber hinaus ein Beschichten mit einem leitenden oder halbleitenden Polymer. Auch die Beschichtung mit einem nichtleitenden Material, in das leitfähige Partikel eingebettet sind, um die Beschichtung leitfähig zu machen, kann beispielsweise genutzt werden.

Bei Ausführungsbeispielen der Erfindung ist es auch möglich, dass die leitfähige Schicht das Substrat nur teilweise bedeckt. Für das erfindungsgemäße Verfahren ist es ausreichend, wenn die leitfähige Schicht einen solchen Flächenbereich umfasst, so dass die elektrostatische Anziehung zwischen der leitfähigen Schicht und der Flächenelektrode ein Fixieren des Substrats sicherstellt. Für eine elektrostatische Aktivierung der Haltekraft können unipolare oder bipolare Trägerplatten verwendet werden.

Im Fall eines bipolaren Trägers sind mindestens zwei getrennte Flächenelektroden vorgesehen, die vorzugsweise mit einer elektrisch isolierenden Schicht überzogen sind, wobei die Flächenelektroden über zwei Kontaktflächen mit Ladungen entgegengesetzter Polarität aufgeladen werden. Wird das Substrat mit elektrisch leitender Schicht aufgelegt, so wird es von den elektrostatischen Feldern der Flächenelektroden der Trägerplatte festgehalten. Bei dieser bipolaren Trägerkonfiguration werden weder das Substrat noch dessen leitfähige Schicht elektrisch kontaktiert oder aufgeladen.

Im Fall des unipolaren Trägers weist die Trägerplatte eine Flächenelektrode auf, die ebenfalls vorzugsweise mit einer Isolierschicht versehen ist, wobei die Isolierschicht die Flächenelektrode nicht vollständig bedecken muss und zum Beispiel Kontaktflächen freigelassen sein können. Als Gegenelektrode wird die elektrisch leitende Schicht des aufgelegten Substrats genutzt. Zur Aktivierung der elektrostatischen Anziehung wird die unipolare Flächenelektrode auf der Trägerplatte und die leitfähige Schicht des Substrats gegenpolig aufgeladen. Die Isolierschicht, die auf die Flächenelektrode des Trägers aufgebracht ist, verhindert einen Kurzschluss zwischen der Flächenelektrode und der leitfähigen Schicht. Die unipolare Anordnung zur elektrostatischen Fixierung von Substraten ist besonders vorteilhaft, da die Haltekraft höher ist als bei der bipolaren Trägerplatte und weil in einem besonders einfachen Ausführungsbeispiel keine weiteren Strukturierungen der Flächenelektrode und der leitfähigen Schicht notwendig sind.

Zur Kontaktierung und Aufladung kommen verschiedene Varianten infrage. In einer erfindungsgemäßen Vorrichtung, weist der Träger neben der Flächenelektrode zumindest eine Kontaktelektrode auf, die derart nebeneinander angeordnet sind, dass beim Anordnen des Substrats auf dem Träger die leitfähige Schicht des Substrats die Kontaktelektrode kontaktiert und die leitfähige Schicht des Substrats von der Flächenelektrode durch eine Isolierschicht getrennt ist. Später werden noch weitere Varianten erläutert.

Bei Ausführungsbeispielen der Erfindung wird das Substrat mit einer zumindest schwach leitfähigen Schicht beschichtet, um dasselbe durch eine reversible elektrostatische Fixierung an einer aufladbaren Trägerplatte fixieren zu können. Für die Beschichtung kann bevorzugt ein polymeres Material wie Polyanilin oder PEDOT (PEDOT = Poly-3,4-Ethylenedioxythiophene) verwendet werden.

Bei Ausführungsbeispielen der Erfindung wird das Substrat mit der leitfähigen Schicht auf einer elektrostatischen Trägerplatte flächig angeordnet. Eine unipolare Ausführung des Trägers ist hierbei bevorzugt.

Bei Ausführungsbeispielen der Erfindung wird dann eine elektrische Spannung zwischen der leitfähigen Schicht des Substrats und der Flächenelektrode des Trägers angelegt, bzw. im Fall des bipolaren Trägers eine Spannung zwischen den beiden Flächenelektroden des Trägers angelegt. Das erfindungsgemäße Verfahren kann ferner die Schritte des Entladens der Flächenelektroden und des Lösens des Substrats vom Träger zu einem gewünschten Zeitpunkt aufweisen.

Bei weiteren Ausführungsbeispielen umfasst das erfindungsgemäße Verfahren ferner ein Ausführen von Bearbeitungsschritten am Substrat wie eine Beschichtung, Lithografie, Trocknungs- oder Heizprozesse, Strukturierungsprozesse, Dünnen, Schleifen und dergleichen.

Für die Beschichtung des Substrats wie beispielsweise eines Foliensubstrats mit der leitfähigen Schicht können verschiedene Verfahren infrage kommen. Leitfähige Polymere können beispielsweise durch einen Rakel-Prozess, Aufschleudern ("spin-coating"), Tauchbeschichtung, Auflaminieren einer leitfähigen Schicht, Siebdruck, Sprühbeschichtung, Rotationsdruckverfahren oder Ink-Jet-Verfahren aufgebracht werden. Metallschichten (A1, Cu, Ti, Cr,....) können beispielsweise durch "Sputtern", Bedampfen, Prägen, Auflaminieren einer Metallfolie oder elektro-chemischen bzw. chemischen Abscheideverfahren aufgebracht werden.

Als Materialien für eine leitfähige polymere Beschichtung kommen beispielsweise in Betracht: PEDOT, Polyanilin und leitfähige Pasten (z. B. gefüllt mit Metall- oder Kohlenstoff-Partikeln).

Als Foliensubstratmaterialien kommen beispielsweise folgende in Betracht: PET (Poly-Ethylen-Terephtalat), PEN (Poly-Ethylen-Naphtalat), Papier, PVC (Polyvinylchlorid), Polycarbonat und auch weitere nicht-leitende Kunststofffolien. Die Substrate können sowohl einzelne Bögen sein als auch aufgewickeltes Rollenmaterial, das nach Abwicklung durch das erfindungsgemäße Verfahren fixiert werden kann.

Als Material für die Trägerplatte kommen beispielsweise Glas oder Kunststoff infrage, und die isolierende Schicht kann beispielsweise aus PET, Polyimid, Glas oder Kunststoff bestehen.

Das erfindungsgemäße Verfahren ist nicht auf die Halterung von Substraten wie Folien beschränkt, sondern es kann in analoger Weise auch zu einer reversiblen Stabilisierung von sehr dünnen und daher ebenfalls flexiblen Halbleitersubstraten ("Wafern") genutzt werden.

Das erfindungsgemäße Konzept bietet eine ganze Reihe von Vorteilen gegenüber bekannten Verfahren und Vorrichtungen. So können beispielsweise nicht formstabile Materialien, wie flexible Folien, sehr einfach auf ein starres Trägersubstrat fixiert werden und ebenso einfach wieder gelöst werden. Diese Trägertechnik ist temperaturstabil und die Trägerplatten sind wiederverwendbar. Es müssen keine zusätzlichen Klebeprozesse durchgeführt werden. Eine Kontamination mit Chemikalien oder Lösungsmitteln aus Klebstoffen oder Wachs wird vermieden. Auch sind keine Reinigungen nach dem Lösen des Substrats vom Träger erforderlich. Die Isolierschicht kann entsprechend den Anforderungen der gewünschten Bearbeitungsprozesse gewählt werden.

Das Trägersystem gewährleistet einen vollflächigen und sehr ebenen Kontakt zwischen Substrat und Trägerplatte. Dies ist für Beschichtungen, Schichthärtungen und lithografische Strukturierungen von großer Bedeutung. Es ist zu erwarten, dass sehr gleichmäßige Schichtdicken erzielt werden können und die Schichten nur wenig verspannt sind, bzw. die Schichten einen gut reproduzierbaren Schichtstress aufweisen. Dies ist mit dem bislang bekannten Stand der Technik nicht erreichbar.

Außerdem bietet das erfindungsgemäße Konzept den Vorteil, dass die Schicht mit dem leitfähigen Material das Substrat vor starken elektrischen Feldern schützt. Dies ist insbesondere bedeutsam, wenn das Substrat empfindliche Schaltungen enthält, die durch starke elektrische Felder beschädigt werden könnten.

Schließlich ist es ein Vorteil der vorliegenden Erfindung, dass nicht nur das Fixieren, sondern auch das Lösen der Substrate problemlos möglich ist. Das Ein- und Ausschalten der Haltekraft erfolgt über das Auf- und Entladen der Flächenelektroden bzw. der leitfähigen Schicht. Dazu werden die Elektroden entladen, wodurch die elektrostatische Kraft nicht mehr wirkt. Das Fixieren und Lösen der Substrate kann überdies sehr schnell und automatisiert erfolgen.

Bevorzugte Ausführungsbeispiele der vorliegenden Erfindung werden nachfolgend bezugnehmend auf die beiliegende Zeichnung näher erläutert. Es zeigen:
- Fig. 1a: eine Flächenelektrode auf einem Träger;
- Fig, 1b: eine Draufsicht auf einen Träger mit Isolierschicht;
- Fig, 1c: ein Querschnitt durch einen unipolaren Träger mit Isolierschicht;
- Fig. 2: ein Querschnitt eines elektrostatisch gehaltenen Substrats auf einem unipolaren Träger;
- Fig. 3a: eine Draufsicht auf einen unipolaren Träger mit Kontaktelektrode für ein aufgelegtes Substrat;
- Fig. 3b: ein Querschnitt eines unipolaren Trägers mit Kontaktelektrode und ein Substrat;
- Fig. 4: ein Querschnitt eines bipolaren Trägers und ein Substrat.

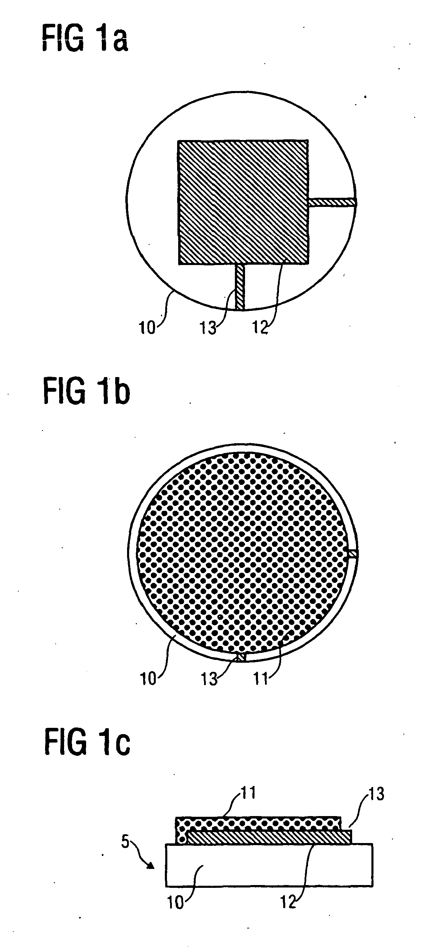

Fig. 1a bis Fig. 1c zeigen ein Ausführungsbeispiel eines unipolaren Trägers 5, der bei einem erfindungsgemäßen Verfahren verwendet werden kann. Der Träger 5 umfasst eine Trägerplatte 10, die bei dem gezeigten Beispiel rund ist und beispielsweise aus Glas bestehen kann. Der Träger 5 umfasst ferner leitfähige Strukturen, die eine Flächenelektrode 12 und Kontaktstellen 13 definieren und eine Isolierschicht 11. Fig. 1a zeigt eine Draufsicht auf den Träger 5, bei der die Isolierschicht 11 zu Darstellungszwecken weggelassen worden ist. Fig. 1b zeigt einen Träger 5 mit aufgebrachter Isolierschicht 11, die zumindest die beiden Kontaktstellen 13 freilässt. Schließlich zeigt Fig. 1c einen Querschnitt durch den Träger 5 bestehend aus dem Trägerplatte 10, der Flächenelektrode 12 und der Isolierschicht 11, die die Kontaktstellen 13 freilässt.

Die Größe der Flächenelektrode 12 entspricht dabei vorzugsweise in etwa der Größe eines zu haltenden Substrats, wobei es vorteilhaft sein kann, die Flächenelektrode 12 etwas größer als das zu haltende Substrat auszulegen, da auf diese Weise eine vollflächige Haltekraft erzeugt werden kann. Wenn die Dicke der Trägerplatte 10 ca. 0,3 bis 1 mm beträgt, so kann eine solche runde Platte sehr gut von Standardhandhabungssystemen verarbeitet werden. Für die Funktion der elektrostatischen Halterung gibt es allerdings keine Einschränkung bezüglich der Dicke oder den äußeren Abmessungen der Trägerplatte 10. Für Handhabung und Prozessierung von Substraten kann eine runde Ausführung vorteilhaft sein, da sich manche Beschichtungsprozesse ("spin coating") leicht ausführen lassen. Grundsätzlich können aber auch rechteckige Trägerplatten 10 mit Kantenlängen im Zentimeter bis Meterbereich verwendet werden.

Die Flächenelektrode 12 kann an den Kontaktstellen 13 kontaktiert und aufgeladen werden. Außerhalb der Kontaktstellen 13 ist die Flächenelektrode 12 bei dem hier gezeigten Ausführungsbeispiel an der Oberfläche mit der Isolierschicht 11 versehen. Die Isolierschicht 11 kann einlagig oder mehrlagig aus dielektrischen Materialien bestehen. Beispiele sind Glas, Kunststoff (z.B. PET, Polyimid) und Materialien mit einer hohen Dielektrizitätskonstante bzw. leicht polarisierbare Materialien.

Ein besonders einfaches und preiswertes Ausführungsbeispiel für den Träger 5 ist ein Aufkleben einer metallbeschichteten PET-Folie auf eine Glasplatte in einer Weise, dass die Metallseite (z. B. Cu, Al) zum Glas zeigt und die isolierende PET-Folie die Isolierschicht 11 darstellt. Zur Ankontaktierung der Metallschicht kann die aufgeklebte Folie an einer Stelle etwas über den Rand der Trägerplatte 10 hinausstehen. Weitere Möglichkeiten zur Kontaktierung ist ein Herstellen eines Kontaktlochs durch die PET-Isolation in einem Randbereich der Trägerplatte 10 oder ein Herstellen von Kontaktlöchern in der Trägerplatte 10.

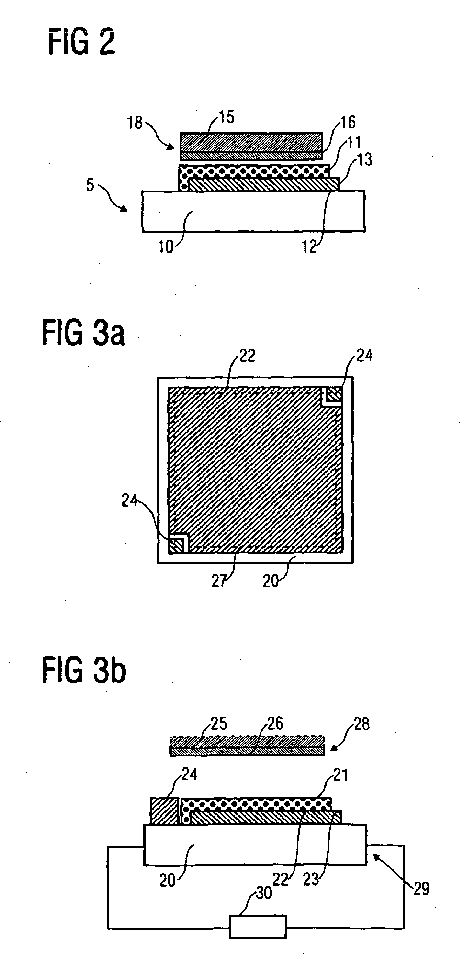

Fig. 2 zeigt einen Querschnitt des Trägers 5 mit einem aufgelegten Substrat 18, das eine leitfähige Schicht 16 auf einem Substratmaterial 15 aufweist. Das Substrat 18 ist derart auf den Träger 5 aufgelegt, dass die Isolierschicht 11 zwischen der leitfähigen Schicht 16 und der Flächenelektrode 12 angeordnet ist. Zur Aktivierung einer elektrostatischen Haltekraft wird zwischen der Kontaktstelle 13 und der leitfähigen Schicht 16 eine Spannung einer Spannungsquelle angelegt. Nach dem Aufladen mit einer Spannung von beispielsweise 50 bis 1000 Volt, wird die Spannungsquelle abgekoppelt, so dass entgegengesetzte Ladungen auf der elektrischen leitfähigen Schicht 16 und der Flächenelektrode 12 verbleiben und das Substrat 18 an dem Träger 5 elektrostatisch fixiert bleibt. Das Substrat 18 kann später nach einer Entladung der leitfähigen Schicht 16 und der Flächenelektrode 12 entfernt werden.

Für das elektrostatische Fixieren des Substrats 18 auf einem Träger 5 gemäß dem Ausführungsbeispiel in Fig. 1a bis Fig. 1c bieten sich zwei Möglichkeiten:
Erstens kann eine Spannung zwischen der Flächenelektrode 12 des Trägers 5 und der leitfähigen Schicht 16 des zu haltenden Substrats 18 vor einem Zusammenlegen des Substrats 18 und des Trägers 5 angelegt werden. Nach Entfernen der Spannungsquelle bleiben genügend Ladungen auf der Flächenelektrode 12 und der leitfähigen Schicht 16 erhalten, um diese in einer Plattenkondensatorkonfiguration aufeinander zu legen und eine hohe Haltekraft zwischen Träger 5 und Substrat 18 zu ermöglichen.

Gemäß einer zweiten Möglichkeit kann das Substrat 18 zunächst locker auf die Isolierschicht 11 des Trägers 5 gelegt werden. Eine Kontaktierung der nun unten liegenden leitfähigen Schicht 16 des Substrats 18 ist über eine sehr dünne, kurze Folienelektrode (nicht gezeigt in den Figuren), die am Rand zwischen der Isolierschicht 11 und der leitfähigen Schicht 16 des Substrats 18 geschoben wird, immer noch gut und einfach möglich. Die Folienelektrode wird nach dem Aufladevorgang einfach unter dem dann bereits fixierten aufgelegten Substrat 18 wieder herausgezogen. Diese Kontaktiermethode kann bevorzugt sein, da so höhere Ladezustände an den Elektroden erreicht werden und die Haltekräfte dementsprechend höher und dauerhafter sind. Die Kontaktierung der Flächenelektrode 12 erfolgt weiterhin über die Kontaktstelle 13.

In Fig. 3a und 3b ist ein neuartiger Träger 29 zum elektrostatischem Fixieren eines Substrats 28 gezeigt. Fig. 3a zeigt eine Draufsicht auf eine Trägerplatte 20, die eine Flächenelektrode 22 und die im Randbereich an zwei diagonal gegenüberliegenden Positionen Metallflächen bzw. Kontaktelektroden 24, die von der Flächenelektrode 22 elektrisch isoliert sind, aufweist. In Fig. 3b ist ein Querschnitt gezeigt, der den Träger 29 mit der Flächenelektrode 22 und der Kontaktelektrode 24 zeigt. Die Flächenelektrode 22 wird wiederum von einer Isolierschicht 21 bedeckt, die eine Kontaktstelle 23 und die Kontaktelektroden 24 freilässt. Zu Darstellungszwecken ist die Isolierschicht 21 in Fig. 3a weggelassen. Das Substrat 28.mit einer leitfähigen Schicht 26 wird derart auf diesen Träger 29 positioniert, dass die leitfähige Schicht 26 auf der Isolierschicht 21 liegt und gleichzeitig Kontakt zu zumindest einer der Kontaktelektroden 24 erhält. Nach Auflegen des Substrats 28 wird die leitfähige Schicht 26 also automatisch kontaktiert und die Flächenelektrode 22 und die leitfähige Schicht 26 können während oder nach dem Aufeinanderlegen leicht und sicher gegenpolig durch eine Einrichtung zum Anlegen einer Spannung 30 aufgeladen werden.

Die Kontaktelektroden 24 müssen nicht die in den Fig. 3a und 3b gezeigte Form und Position aufweisen. Ferner kann eine andere Anzahl als zwei Kontaktelektroden 24, beispielsweise nur eine, vorgesehen sein. Die Anordnung der Kontaktelektroden 24 ist derart, dass beim Aufbringen des Substrats 28 auf den Träger 29 ein sicherer Kontakt zumindest einer Kontaktelektrode 24 mit der leitfähigen Schicht 26 sichergestellt werden kann. In Fig. 3a ist eine Position für das Substrat 28 durch eine gestrichelte Linie 27 gekennzeichnet. Ebenso können die Form und die Größe der Flächenelektrode 22 und die Form und die Größe der leitfähigen Schicht 26 von der gezeigten Form und Größe abweichen, wobei sie derart ausgestaltet sind, dass ein sicheres Fixieren des Substrats 28 auf dem Träger 29 erfolgen kann.

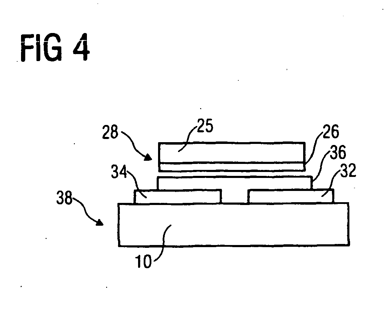

Fig. 4 zeigt einen bipolaren Träger 38, der aus einer ersten Flächenelektrode 32 und einer zweiten Flächenelektrode 34 besteht. Die erste Flächenelektrode 32 und die zweite Flächenelektrode 34 weisen bei dem hier gezeigten Ausführungsbeispiel eine Isolierschicht 36 auf. Das Substrat 28 wird auf dem Träger 38 derart positioniert, dass die leitfähige Schicht 26 auf der Isolierschicht 36 liegt und die Fixierung durch Aufbringen von Ladungen unterschiedlicher Polarität auf die erste Flächenelektrode 32 und die zweite Flächenelektrode 34 erfolgt. Ein Lösen der Halterung erfolgt wie bei den anderen Ausführungsbeispielen auch durch ein Entladen der ersten Flächenelektrode 32 und der zweiten Flächenelektrode 34, wodurch die elektrostatische Anziehung verschwindet. Zum Fixieren des Substrats 28 ist eine Einrichtung zum Anlegen einer Spannung erforderlich, die in Fig. 4 nicht gezeigt ist.

Bei anderen Ausführungsbeispielen ist die Isolierschicht nicht Bestandteil des Trägers. Die Isolierschicht kann beispielsweise auch ein Bestandteil des Substrats sein. Bei weiteren Ausführungsbeispielen kann die Isolierschicht flächenmäßig kleiner ausgebildet sein als in den Figuren gezeigt, solange sie einen elektrischen Kurzschluss beim elektrostatischen Aufladen verhindert. Zum Fixieren des Substrats ist es lediglich notwendig, die Spannung solange anzuliegen wie zur elektrostatischen Aufladung der leitfähigen Schicht und der Flächenelektrode bzw. der ersten Flächenelektrode und der zweiten Flächenelektrode erforderlich ist. Danach kann die Spannung abgeschaltet bzw. die Kontaktelektroden abgenommen werden. Ein Lösen des Substrats kann schließlich durch das Entladen der leitfähigen Schicht und der Flächenelektrode bzw. der ersten Flächenelektrode und der zweiten Flächenelektrode erfolgen.

Die vorliegende Erfindung kann in einer Vielzahl von Einsatzgebieten Anwendung finden. Eine konkrete Anwendung der vorliegenden Erfindung ist das Fixieren von Substraten, für die ein Rückseitendünnen vorgenommen werden soll, also z.B. bei Halbleiter-Substraten wie Silizium-Wafern. Nach heutigen Dünnungsverfahren werden fertig prozessierte Schaltungswafer auf ihrer Vorderseite mit einer polymeren Schutzfolie ("backgrinding tape") beklebt. Die Wafer werden anschließend mittels einer Schleifmaschine ("grinding") von der Rückseite her dünngeschliffen, typischerweise bis zu einer Restdicke von 80 bis 200 µm. Um schleifinduzierte Kristallschäden an der Rückseite zu entfernen, werden die Wafer danach einem sogenannten "Stress-Relief"-Prozess unterzogen, der beispielsweise ein nass-chemischer Spinätz-Prozess oder Plasmaätz-Prozess sein kann. Hier ist die vorliegende Erfindung vorteilhaft einsetzbar, indem diese Schutzfolie mit einer elektrisch leitfähigen Schicht versehen wird, so dass man den gedünnten Wafer nach dem Schleifen auf einem elektrostatischen Träger fixieren und ihn auf diese Weise ohne Bruchrisiko weiter abdünnen kann, beispielsweise in einem Spin-Ätz-Prozess. Der besondere Vorteil hierbei ist, dass die Wafer-Vorderseite weiterhin durch die polymere Schutzfolie abgedeckt bleibt, d. h. das Ätzmedium kann keinen Schaden an den Schaltungsstrukturen anrichten.

Außerdem entfällt durch die Einführung des elektrostatischen Trägersystems für den Ätzprozess das Bruchrisiko beim Dünnen, d. h. der Wafer kann ohne weitere Schwierigkeiten und ohne Änderungen der Anlagen und Robot-Systeme auf Dicken von 5 bis 80 µm abgedünnt werden. Zuletzt wird die Schutzfolie wieder abgezogen. Aus dem "backgrinding tape" wird somit ein elektrostatisch aktivierbarer Hilfsträger, der zusammen mit dem Wafer, an dem derselbe angebracht ist, auf einem starren Träger reversibel fixiert werden kann.

Darüber hinaus kann die vorliegende Erfindung noch eine Reihe weiterer Vorteile bieten. So kann der Träger 5 eine einfache Platte sein, die leicht transportierbar ist, und die insbesondere mit den gängigen Produktionstechniken zum Substrathandling sofort nutzbar ist. Der Träger 5 braucht keine ringförmige Struktur haben und kann auch kleinere Abmessungen aufweisen (ein Horden-Handling wird dadurch möglich gemacht). Außerdem wird das Substrat 18 vollflächig unterstützt, da der Träger 5 beispielsweise eine starre und ebene Unterstützung bieten kann, die keine Spalten oder Löcher braucht. Damit ist der Träger 5 auch für Prozesse wie beispielsweise das Aufschleudern eines Polymers (spin-coating) einsetzbar. Der Träger 5 kann somit insbesondere ein mobiles Trägersubstrat aufweisen, welches drehbar oder allgemein beweglich ausgestaltet sein kann und zum Beispiel in eine Aufnahmevorrichtung (beispielsweise eine Waferhandhabungsvorrichtung) aufgenommen und transportiert werden kann. Dies kann insbesondere auch nach dem vorrübergehenden Anliegen der Spannung erfolgen, da das Substrat 18 auch nach dem Ablegen der Spannung fixiert bleibt. Im Weiteren ist die Elektrode 22 auf dem Träger 5 bis auf die Kontaktstelle 23 voll geschützt.

Bei weiteren Ausführungsbeispielen kann das flexible Substrat neben Kunststofffolien und dünnen Halbleitern auch dünne, biegsame Glas- oder Keramiksubstrate aufweisen. Au-βerdem kann bei weiteren Ausführungsbeispielen der Vorgang des elektrostatischen Fixierens (Anlegen einer Spannung zwischen den Elektroden) auch unter Vakuumbedingungen erfolgen, zum Beispiel innerhalb einer Vakuumkammer durchgeführt werden. Das kann zum Beispiel dahingehend vorteilhaft sein, dass sich dadurch Luftblasen, die andererseits zwischen Substrat (Folie) und Träger eingeschlossen sein könnten, vermeiden lassen. Bei einer Kontaktierung unter Luft (außerhalb einer Vakuumkammer bzw. unter normalen Luft.druckbedingungen) sind solche Blasen nicht auszuschließen und können zu Aufwölbungen führen, was für spätere Prozesse (z.B. Sputtern, Plasmaätzen) unter Vakuumbedingungen nachteilig ist.

## Patentansprüche

1. Vorrichtung zum Fixieren eines Substrats (28), das eine leitfähige Schicht (26) aufweist, mit folgenden Merkmalen:
einer Trägerplatte (20); und
einer Flächenelektrode (22), die auf der Trägerplatte (20) ausgebildet ist, wobei eine Isolierschicht auf der Flächenelektrode ausgebildet ist; **gekennzeichnet durch**
eine Kontaktelektrode (24), die auf der Trägerplatte (20) derart ausgebildet ist, dass beim Anordnen des Substrats (28) auf der Trägerplatte (20) die leitfähige Schicht (26) über die Isolierschicht (21) der Flächenelektrode (22) gegenüberliegt und die Kontaktelektrode (24) die leitfähige Schicht (26) auf dem Substrat (28) kontaktiert,
wobei die Isolierschicht (21) und die Kontaktelektrode (24) eine ebene Fläche definieren und (20) eine vollflächige Kontaktfläche für das Substrat (28) bieten.

2. Vorrichtung gemäß Anspruch 1, die zwei voneinander beabstandete Kontaktelektroden (24) aufweist.

3. Vorrichtung gemäß einem der Ansprüche 1 oder 2, die ferner eine Vorrichtung zum Anlegen einer Spannung (30) zwischen einer Kontaktstelle (23) und der Kontaktelektrode (24) aufweist.

4. Vorrichtung gemäß einem der Ansprüche 1 bis 3, bei der Flächenelektrode (22) eine Metallbeschichtung einer Kunststofffolie ist und derart auf die Trägerplatte (20) aufgebracht ist, dass die Metallbeschichtung zwischen der Kunststofffolie und der Trägerplatte (20) angeordnet ist.

5. Vorrichtung gemäß einem der Ansprüche 1 bis 4, bei der die Trägerplatte (20) ein mobiles Trägersubstrat aufweist.

6. Vorrichtung gemäß einem der Ansprüche 1 bis 5, bei der die Trägerplatte (20) ausgebildet ist, um durch eine Aufnahmevorrichtung aufnehmbar und transportierbar zu sein, während das Substrat (28) durch die elektrostatische Anziehung fixiert ist.

7. Vorrichtung gemäß einem der Ansprüche 1 bis 6, bei der die Trägerplatte (20) ausgebildet ist, um durch eine Waferhandhabungsvorrichtung handhabbar zu sein.

8. Vorrichtung gemäß einem der Ansprüche 1 bis 7, bei dem die Trägerplatte (20) in einer Vakuumkammer angeordnet ist.

9. Verfahren zum Handhaben eines Substrats (18; 28) mit folgenden Schritten:
Bereitstellen eines Substrats (18; 28), das eine leitfähige Schicht (16; 26) aufweist;
Bereitstellen einer Vorrichtung nach einem der Ansprüche 1 bis 8 als Träger (29);
Anordnen des Substrats (28) und des Trägers (29) derart, dass sich die leitfähige Schicht (26) und die Flächenelektrode (22) über die Isolierschicht (21) gegenüberliegen; und
Bewirken einer elektrostatischen Anziehung durch ein vorübergehendes Anlegen einer Spannung zwischen der leitfähigen Schicht (26) und der Flächenelektrode leitfähigen Schicht (26) und der Flächenelektrode (22) zum Fixieren des Substrats (28) an dem Träger (29),
wobei die leitfähige Schicht (26) und die Flächenelektrode (22) derart ausgebildet sind, dass nach dem vorübergehenden Anlegen der Spannung das Substrat (28) durch elektrostatische Anziehung an dem Träger (29) fixiert bleibt und das Substrat (28) flexibel ist.

10. Verfahren gemäß Anspruch 9, bei dem das Substrat (28) eine Kunststofffolie, ein flexibles Halbleitersubstrat, ein biegsames Glassubstrat oder ein biegsames Keramiksubstrat aufweist.

11. Verfahren gemäß einem der Ansprüche 9 oder 10, bei dem das Substrat (28) eine Kunststofffolie oder ein flexibles Halbleitersubstrat ist.

12. Verfahren gemäß einem der Ansprüche 9 bis 11, bei dem die leitfähige Schicht (26) ein polymeres Material oder eine leitfähigen Paste ist.

13. Verfahren gemäß einem der Ansprüche 9 bis 12, bei der der Schritt des vorübergehenden Anlegens einer Spannung ausgeführt wird, bevor das Substrat (28) und der Träger (29) zusammengebracht werden.

14. Verfahren gemäß einem der Ansprüche 9 bis 13, bei der der Schritt des vorübergehenden Anlegens einer Spannung ausgeführt wird, nachdem das Substrat (28) und der Träger (29) zusammengebracht wurden.

15. Verfahren gemäß einem der Ansprüche 9 bis 14, das ferner einen Schritt des Bearbeitens des auf dem Träger (5; 29; 38) fixierten Substrats (18; 28) aufweist.

16. Verfahren gemäß einem der Ansprüche 9 bis 15, bei dem der Schritt des Bereitstellens des Substrats (18; 28) einen Schritt des Aufbringens der leitfähigen Schicht (16; 26) auf eine Seite eines Substratmaterials (15; 25) aufweist.

17. Verfahren gemäß einem der Ansprüche 9 bis 16, bei dem der Schritt des Bereitstellens des Substrats (18; 28) ferner einen Schritt eines Aufbringens einer Schutzfolie mit einer leitfähigen Schicht (16; 26) auf eine Seite des Substratmaterials (15; 25) aufweist.

18. Verfahren gemäß Anspruch 16 oder 17, bei dem der Schritt des Bereitstellens des Substrats (18; 28) ferner einen Schritt eines Dünnens des Substrats (18; 28) auf einer Seite, die der Seite, auf die die leitfähige Schicht (16; 26) oder die Schutzfolie aufgebracht wird oder wurde, gegenüberliegt, aufweist.

19. Verfahren gemäß Anspruch 17 oder 18, das ferner einen Schritt des Schleifens des Substrats (18; 28) auf der der leitfähigen Schicht (16; 26) oder Schutzfolie gegenüberliegenden Seite aufweist.

20. Verfahren gemäß einem der Ansprüche 18 oder 19, das ferner einen Schritt des Entfernens der Schutzfolie nach dem Schritt des Schleifens des Substrats (18; 28) aufweist.

21. Verfahren gemäß einem der Ansprüche 9 bis 20, bei dem der Schritt des Bewirkens einer elektrostatischen Anziehung in einem Vakuum erfolgt.

22. Verfahren gemäß einem der Ansprüche 9 bis 21, bei dem der Schritt des Bereitstellens des Trägers (29) ein Bereitstellen eines mobilen Trägersubstrats umfasst.

23. Verfahren gemäß einem der Ansprüche 9 bis 22, bei dem der Schritt des Bereitstellens des Trägers (29) das Bereitstellen eines Trägers (29) umfasst, der ausgebildet ist, um durch eine Aufnahmevorrichtung aufgenommen und transportiert zu werden, während das Substrat (28) durch die elektrostatische Anziehung fixiert ist.

24. Verfahren gemäß einem der Ansprüche 9 bis 23, bei dem der Schritt des Bereitstellens des Trägers (29) das Bereitstellen eines Trägers (29) umfasst, der ausgebildet ist, um durch eine Waferhandhabungsvorrichtung gehandhabt zu werden.

## Claims

1. Device for securing a substrate (28) comprising a conductive layer (26), comprising:
a support plate (20); and
an area electrode (22) formed on the support plate (20), wherein an insulating layer is formed on the area electrode; **characterized by**
a contact electrode (24) formed on the support plate (20), such that when arranging the substrate (28) on the support plate (20), the conductive layer (26) faces the area electrode (22) across the insulating layer (21) and the contact electrode (24) contacts the conductive layer (26) on the substrate (28),
wherein the insulating layer (21) and the contact electrode (24) define a plane area and provide a full-surface contact area for the substrate (28).

2. Apparatus according to claim 1 comprising two contact electrodes (24) spaced apart from one another.

3. Apparatus according to claims 1 or 2, further comprising an apparatus for applying a voltage (30) between a contact point (23) and the contact electrode (24).

4. Apparatus according to claims 1 to 3, wherein the area electrode (22) is a metal coating of a plastic foil and is deposited on the support plate (20) such that the metal coating is arranged between the plastic foil and the support plate (20).

5. Apparatus according to one of claims 1 to 4, wherein the support plate (20) comprises a mobile support substrate.

6. Apparatus according to one of claims 1 to 5, wherein the support plate is implemented to be receivable and transportable by a receiving device, while the substrate (28) is secured by the electrostatic attraction.

7. Apparatus according to one of claims 1 to 6, wherein the support plate (20) is implemented to be manageable by a wafer managing device.

8. Apparatus according to one of claims 1 to 7, wherein the support plate (20) is arranged in a vacuum chamber.

9. Method for managing a substrate (18; 28), comprising:
providing a substrate (18; 28) comprising a conductive layer (16; 26);
providing a device according to one of claims 1 to 8 as support (29);
arranging the substrate (28) and the support (29) such that the conductive layer (26) and the area electrode (22) face one another across the insulating layer (21); and
effecting an electrostatic attraction by temporarily applying a voltage between the conductive layer (26) and the area electrode (22) for securing the substrate (28) on the support (29),
wherein the conductive layer (26) and the area electrode (22) are implemented such that after temporarily applying the voltage, the substrate (28) remains secured on the support (29) by electrostatic attraction and the substrate (28) is flexible.

10. Method according to claim 9, wherein the substrate (28) comprises a plastic foil, a flexible semiconductor substrate, a bendable glass substrate or a bendable ceramic substrate.

11. Method according to one of claims 9 or 10, wherein the substrate (28) is a plastic foil or a flexible semiconductor substrate.

12. Method according to one of claims 9 to 11, wherein the conductive layer (26) is a polymer material or a conductive paste.

13. Method according to one of claims 9 to 12, wherein the step of temporarily applying a voltage is performed before the substrate (28) and the support (29) are united.

14. Method according to one of claims 9 to 13, wherein the step of temporarily applying a voltage is performed after the substrate (28) and the support (29) have been united.

15. Method according to one of claims 9 to 14, further comprising a step of processing the substrate (18; 28) fixed on the support (5; 29; 38).

16. Method according to one of claims 9 to 15, wherein the step of providing the substrate (18; 28) comprises a step of depositing the conductive layer (16; 26) on a side of a substrate material (15; 25).

17. Method according to one of claims 9 to 16, wherein the step of providing the substrate (18; 28) further comprises a step of depositing a protective foil with a conductive layer (16; 26) on a side of the substrate material (15; 25).

18. Method according to claims 16 or 17, wherein the step of providing the substrate (18; 28) further comprises a step of thinning the substrate (18; 28) on a side facing the side on which the conductive layer (16; 26) or the protective foil is deposited or has been deposited.

19. Method according to claims 17 or 18, further comprising a step of polishing the substrate (18; 28) on the side facing the conductive layer (16; 26) or protective layer.

20. Method according to one of claims 18 or 19, further comprising a step of removing the protective foil after the step of polishing the substrate (18; 28).

21. Method according to one of claims 9 to 20, wherein the step of effecting an electrostatic attraction is performed in a vacuum.

22. Method according to one of claims 9 to 21, wherein the step of providing the support (29) comprises providing a mobile support substrate.

23. Method according to one of claims 9 to 22, wherein the step of providing the support (29) comprises providing a support (29), which is implemented to be received and transported by a receiving device, while the substrate (28) is secured by electrostatic attraction.

24. Method according to one of claims 9 to 23, wherein the step of providing the support (29) comprises providing a support (29), which is implemented to be managed by a wafer managing device.

## Revendications

1. Dispositif de fixation d'un substrat (28) présentant une couche conductrice (26), aux caractéristiques suivantes:
une plaque de support (20); et
une électrode de jonction (22) qui est réalisée sur la plaque de support (20), une couche isolante étant réalisée sur l'électrode de jonction;
**caractérisé par**
une électrode de contact (24) qui est réalisée sur la plaque de support (20) de sorte que, lors de la disposition du substrat (28) sur la plaque de support (20), la couche conductrice (26) est, par l'intermédiaire de la couche isolante (21), opposée à l'électrode de jonction (22) et l'électrode de contact (24) entre en contact avec la couche conductrice (26) sur le substrat (28),
la couche isolante (21) et l'électrode de contact (24) définissant une face plane et offrant une face de contact sur toute la surface pour le substrat (28).

2. Dispositif selon la revendication 1, présentant deux électrodes de contact (24) distantes l'une de l'autre.

3. Dispositif selon l'une des revendications 1 ou 2, présentant par ailleurs un dispositif destiné à appliquer une tension (30) entre un point de contact (23) et l'électrode de contact (24).

4. Dispositif selon l'une des revendications 1 à 3, dans lequel l'électrode de jonction (22) est un revêtement métallique d'un film plastique et est appliquée sur la plaque de support (20) de sorte que le revêtement métallique soit disposé entre le film plastique et la plaque de support (20).

5. Dispositif selon l'une des revendications 1 à 4, dans lequel la plaque de support (20) présente un substrat porteur mobile.

6. Dispositif selon l'une des revendications 1 à 5, dans lequel la plaque de support (20) est réalisée pour pouvoir être reçue et transportée par un dispositif de réception, tandis que le substrat (28) est fixé par l'attraction électrostatique.

7. Dispositif selon l'une des revendications 1 à 6, dans lequel la plaque de support (20) est réalisée pour pouvoir être manipulée par un dispositif de manipulation de plaquettes.

8. Dispositif selon l'une des revendications 1 à 7, dans lequel la plaque de support (20) est disposée dans une chambre à vide.

9. Procédé pour manipuler un substrat (18; 28), aux étapes suivantes consistant à:
préparer un substrat (18; 28) qui présente une couche conductrice (16; 26);
préparer un dispositif selon l'une des revendications 1 à 8 comme support (29);
disposer le substrat (28) et le support (29) de sorte que la couche conductrice (26) et l'électrode de jonction (22) soient opposées l'une à l'autre par l'intermédiaire de la couche isolante (21); et
provoquer une attraction électrostatique par une application temporaire d'une tension entre la couche conductrice (26) et l'électrode de jonction (22) pour fixer le substrat (28) au support (29),
la couche conductrice (26) et l'électrode de jonction (22) étant réalisées de sorte que, après l'application temporaire de la tension, le substrat (28) reste fixé au support (29) par attraction électrostatique et que le substrat (28) soit flexible.

10. Procédé selon la revendication 9, dans lequel le substrat (28) présente un film plastique, un substrat semi-conducteur flexible, un substrat de verre souple ou un substrat céramique souple.

11. Procédé selon l'une des revendications 9 ou 10, dans lequel le substrat (28) est un film plastique ou un substrat semi-conducteur flexible.

12. Procédé selon l'une des revendications 9 à 11, dans lequel la couche conductrice (26) est un matériau polymère ou une pâte conductrice.

13. Procédé selon l'une des revendications 9 à 12, dans lequel l'étape d'application temporaire d'une tension est réalisée avant que ne soient assemblés le substrat (28) et le support (29).

14. Procédé selon l'une des revendications 9 à 13, dans lequel l'étape d'application temporaire d'une tension est réalisée après que le substrat (28) et le support (29) aient été assemblés.

15. Procédé selon l'une des revendications 9 à 14, présentant par ailleurs une étape consistant à traiter le substrat (18; 28) fixé sur le support (5; 29; 38).

16. Procédé selon l'une des revendications 9 à 15, dans lequel l'étape de préparation du substrat (18; 28) présente une étape consistant à appliquer la couche conductrice (16; 26) sur un côté du matériau de substrat (15; 25).

17. Procédé selon l'une des revendications 9 à 16, dans lequel l'étape de préparation du substrat (18; 28) présente par ailleurs une étape consistant à appliquer un film protecteur avec une couche conductrice (16; 26) sur un côté du matériau de substrat (15; 25).

18. Procédé selon la revendication 16 ou 17, dans lequel l'étape de préparation du substrat (18; 28) présente par ailleurs une étape consistant à amincir le substrat (18; 28) sur un côté qui est opposé au côté sur lequel est ou a été appliquée la couche conductrice (16; 26) ou le film protecteur.

19. Procédé selon la revendication 17 ou 18, présentant par ailleurs une étape consistant à polir le substrat (18; 28) sur le côté opposé à la couche conductrice (16; 26) ou au film protecteur.

20. Procédé selon l'une des revendications 18 ou 19, présentant par ailleurs une étape consistant à éliminer le film protecteur après le polissage du substrat (18; 28).

21. Procédé selon l'une des revendications 9 à 20, dans lequel l'étape de provocation d'une attraction électrostatique a lieu dans un vide.

22. Procédé selon l'une des revendications 9 à 21, dans lequel l'étape de préparation du support (29) comporte la préparation d'un substrat porteur mobile.

23. Procédé selon l'une des revendications 9 à 22, dans lequel l'étape de préparation du support (29) comporte la préparation d'un support (29) qui est réalisé pour être reçu et transporté par un dispositif de réception, tandis que le substrat (28) est fixé par l'attraction électrostatique.

24. Procédé selon l'une des revendications 9 à 23, dans lequel l'étape de préparation du support (29) comporte la préparation d'un support (29) qui est réalisé pour être manipulé par un dispositif de manipulation de plaquette.
